# EUROPÄISCHE PATENTSCHRIFT

(11) **EP 1 633 026 B1**
(45) Veröffentlichungstag und Bekanntmachung des Hinweises auf die Patenterteilung: **07.09.2016**
(21) Anmeldenummer: 05016014.2
(22) Anmeldetag: 22.07.2005
(51) Int. Cl.: H01S 5/183, H01S 5/14, H01S 5/04, H01S 5/022, H01S 3/109

(54) **Halbleiterbauelement mit einem gekrümmten Spiegel und Verfahren zum Herstellen eines Halbleiterbauelements mit einem gekrümmten Halbleiterkörper**
Semiconductor component with a curved mirror and fabrication method of a semiconductor component having a curved semiconductor body
Composant à semiconducteurs à mirroir courbe et méthode de fabrication d'un composant à semiconducteurs ayant un corps courbe à semiconducteurs

(30) Priorität: 23.08.2004 DE 102004040762; 29.10.2004 DE 102004052686
(43) Veröffentlichungstag der Anmeldung: 08.03.2006
(73) Patentinhaber: OSRAM Opto Semiconductors GmbH, 93055 Regensburg (DE)
(72) Erfinder: Schmid, Wolfgang, 93180 Deuerling/Hillohe (DE); Albrecht, Tony, 93077 Bad Abbach (DE); Steegmüller, Ulrich, 93055 Regensburg (DE); Reill, Wolfgang, 93080 Pentling (DE)
(74) Vertreter: Epping - Hermann - Fischer

(56) Entgegenhaltungen:
- EP-A- 0 740 377
- EP-A- 1 220 392
- US-A- 4 784 722
- US-A- 5 341 390
- US-A- 5 461 637
- US-A- 5 918 108
- US-A1- 2002 163 688
- US-A1- 2003 072 523
- US-A1- 2003 169 797
- US-B1- 6 404 797
- PARVIZ TAYEBATI ET AL: "HALF-SYMMETRIC CAVITY TUNABLE MICROELECTROCHEMICAL VCSEL WITH SINGLE SPATIAL MODE" IEEE PHOTONICS TECHNOLOGY LETTERS, IEEE SERVICE CENTER, PISCATAWAY, NJ, US, Bd. 10, Nr. 12, Dezember 1998 (1998-12), Seiten 1679-1681, XP000802152 ISSN: 1041-1135

## Beschreibung

Die Erfindung betrifft ein Halbleiterbauelement mit einem gekrümmten Spiegel und ein Verfahren zum Herstellen eines Halbleiterbauelements mit einem gekrümmten Halbleiterkörper.

Bei oberflächenemittierenden Halbleiterlasern mit einem externen Resonator und einer vertikalen Emissionsrichtung zur Oberfläche eines Halbleiterkörpers des Lasers, zum Beispiel einem VECSEL (Vertical External Cavity Surface Emitting Laser) oder Halbleiterscheibenlaser, wird der externe Resonator oftmals durch einen im Halbleiterkörper des Halbleiterlasers integrierten ebenen Bragg-Spiegel und einen gekrümmten externen dielektrischen Spiegel gebildet. Über geeignete Krümmung des externen Spiegels und eine hieran angepasste Resonatorlänge kann ein Grundmodenbetrieb des Lasers erzielt werden. Die Justage des gekrümmten Spiegels im dreidimensionalen Raum ist für eine effiziente Lasertätigkeit, insbesondere in der Grundmode, des Halbleiterlasers mit externem Resonator jedoch oftmals aufwendig. Weiterhin ist die Herstellung von gekrümmten optischen Elementen verglichen mit ebenen optischen Elementen vergleichsweise kostenintensiv.

VCSEL (Vertical Cavity Surface Emitting Laser) mit gekrümmten Spiegeln sind in den Druckschriften US 2003/0169797 A1, US 5,461,637 und US 2002/0163688 A1 beschrieben. Diese gekrümmten Spiegel werden jeweils auf einem gekrümmten Abscheidesubstrat hergestellt.

In der Druckschrift EP 0 740 377 A1 ist eine nachteilige Krümmung eines Halbleitersubstrats beschrieben.

Eine Aufgabe der Erfindung ist es, ein vereinfacht und kostengünstig herstellbares Halbleiterbauelement mit einem gekrümmten Spiegel anzugeben. Weiterhin ist es eine Aufgabe der Erfindung, ein vereinfachtes Verfahren zur Herstellung eines entsprechenden Halbleiterbauelements sowie eine Verwendung eines Halbleiterkörpers zur Herstellung eines Halbleiterbauelements anzugeben.

Diese Aufgabe wird durch ein Halbleiterbauelement mit den Merkmalen des Patentanspruchs 1, ein Verfahren gemäß Patentanspruch 17 und eine Verwendung nach Anspruch 29 gelöst. Vorteilhafte Weiterbildungen der Erfindung sind Gegenstand der abhängigen Ansprüche.

Ein erfindungsgemäßes Halbleiterbauelement weist einen Halbleiterkörper auf, wobei der Halbleiterkörper einen gekrümmten Spiegel umfasst, der monolithisch im Halbleiterkörper integriert ist und der Halbleiterkörper auf einem Träger angeordnet ist. Weiterhin ist ein die Krümmung induzierendes oder formendes Krümmungselement auf der dem Träger abgewandten Seite des Halbleiterkörpers angeordnet.

Mit Vorteil kann die Krümmung des Spiegels nach der Herstellung des Halbleiterkörpers, zum Beispiel mittels Epitaxie auf einem geeigneten Aufwachssubstrat, gezielt erzeugt werden. Der Halbleiterkörper ist dementsprechend vorzugsweise eben und ungekrümmt hergestellt und die Krümmung wird nach dem Aufwachsen des Halbleiterkörpers erzeugt.

Im Rahmen der Erfindung kann es also vorgesehen sein, einen epitaktisch auf einem Aufwachssubstrat gewachsenen ebenen Halbleiterkörper, der einen monolithisch integrierten Spiegel aufweist, zur Herstellung eines Halbleiterbauelements mit einem gekrümmten Spiegel zu verwenden. Der gekrümmte Spiegel kann durch Krümmung des Halbleiterkörpers erzeugt werden. Beispielsweise ist zur Krümmung des Spiegels auf dem Halbleiterkörper ein die Krümmung induzierendes oder die Krümmung formendes Krümmungselement angeordnet. Vorzugsweise weisen der Halbleiterkörper und der monolithisch integrierte gekrümmte Spiegel eine gleichartige Krümmung auf. Die Krümmung des Spiegels kann somit durch geeignete Krümmung des Halbleiterkörpers erzeugt werden. Insbesondere kann der gekrümmte Spiegel mit einer gezielten und definierten Krümmung ausgeführt sein.

Ein gekrümmter Spiegel kann so kostengünstig und auf einfache Weise hergestellt werden.

Der Spiegel ist mit Vorzug zur Strahlformung gekrümmt und kann beispielsweise eine konvexe oder konkave, etwa elliptische, sphärische oder eine andersartige zur Strahlformung geeignete Krümmung aufweisen. Weiterhin weist der gekrümmte Spiegel vorzugsweise einen Fokus auf.

In einer bevorzugten Ausgestaltung der Erfindung ist das Krümmungselement eine, vorzugsweise metallhaltige, Verspannungsschicht, die den Halbleiterkörper mittels über die Verspannungsschicht induzierte Druck- oder Zugverspannung krümmt.

In einer weiteren bevorzugten Ausgestaltung der Erfindung ist das Krümmungselement ein Formelement, das einen entsprechend der gewünschten Krümmung geformten Teilbereich aufweist, an den sich der Halbleiterkörper bzw. der Spiegel andrückt oder der an den Halbleiterkörper angedrückt wird und der Halbleiterkörper in der Folge entsprechend dem Formelement gekrümmt wird.

In einer weiteren bevorzugten Ausgestaltung der Erfindung ist der gekrümmte Spiegel ein Bragg-Spiegel. Hierzu ist im Halbleiterkörper vorzugsweise eine Mehrzahl von Halbleiterschichtenpaaren für den Bragg-Spiegel vorgesehen. Die beiden Halbleiterschichten eines Halbleiterschichtenpaares weisen mit Vorteil einen vergleichsweise hohen Brechungsindexunterschied und eine dementsprechend hohe Einzelpaar-Reflektivität auf. Über die Anzahl an Halbleiterschichtenpaaren kann die Gesamtreflektivität des Spiegels eingestellt werden.

In einer weiteren bevorzugten Ausgestaltung der Erfindung ist der Halbleiterkörper auf einem Träger angeordnet, der den Halbleiterkörper mit Vorzug, insbesondere vor der Krümmung des Spiegels, mechanisch stabilisiert und/oder trägt. Der Träger kann insbesondere eben ausgeführt sein.

Der Halbleiterkörper weist weiterhin bevorzugt mindestens einen für den gekrümmten Spiegel gekrümmten Teilbereich und mindestens einen ebenen Teilbereich auf. Der ebene Teilbereich kann den gekrümmten Teilbereich des Halbleiterkörpers hierbei lateral umlaufen. Dem gekrümmten Teilbereich ist in vertikaler Richtung besonders bevorzugt ein Fenster, in dem der Träger abgedünnt oder ausgespart ist, nachgeordnet. Beispielsweise überlappt der gekrümmte Teilbereich in vertikaler Richtung, vorzugsweise vollständig, mit dem Fenster.

Durch eine Abdünnung oder Aussparung kann eine mechanisch stabilisierende Wirkung des Trägers für den Halbleiterkörper im Bereich des Fensters verringert werden, so dass eine Krümmung des Halbleiterkörpers beziehungsweise des Spiegels vereinfacht erfolgen kann. Durch Aussparen des Trägers etwa kann im Bereich des Fensters die Haftung des Halbleiterkörpers auf dem Träger bzw. die mechanisch stabilisierende Wirkung des Trägers reduziert werden und der Halbleiterkörper ist im Bereich des Fensters vereinfacht verformbar, insbesondere in einer Richtung vertikal zu einer lateralen Haupterstreckungsrichtung des Trägers und/oder des Halbleiterkörpers.

In einer weiteren bevorzugten Ausgestaltung der Erfindung weist der Halbleiterkörper eine zur Strahlungserzeugung vorgesehene aktive Zone auf. Das Halbleiterbauelement kann somit insbesondere als strahlungsemittierendes Halbleiterbauelement ausgebildet sein. Die aktive Zone ist bevorzugt gemäß dem gekrümmten Spiegel gekrümmt.

Mit Vorteil weist das strahlungsemittierende Halbleiterbauelement einen in den Halbleiterkörper monolithisch integrierten gekrümmten Spiegel auf, der zur Strahlformung für eine in der aktiven Zone erzeugte Strahlung ausgebildet ist.

In einer weiteren bevorzugten Ausgestaltung der Erfindung ist das Halbleiterbauelement ein oberflächenemittierendes Halbleiterbauelement. Die Hauptemissionsrichtung von in der aktiven Zone erzeugter Strahlung verläuft mit Vorzug im wesentlichen vertikal zur Oberfläche des Halbleiterkörpers die Emissionsoberfläche ist mit besonderem Vorzug die dem gekrümmten Spiegel gegenüberliegende Oberfläche des Halbleiterkörpers.

In einer weiteren bevorzugten Ausgestaltung der Erfindung ist das Halbleiterbauelement zur Erzeugung von Laserstrahlung mittels eines externen Resonators vorgesehen. Für den externen Resonator kann der aktiven Zone ein externer Spiegel nachgeordnet sein. Der externe Spiegel kann hierbei den Resonatorendspiegel bilden und/oder als Auskoppelspiegel von Strahlung aus dem Resonator vorgesehen sein. Insbesondere kann der externe Spiegel im wesentlichen eben ausgeführt sein, da eine Strahlformung mit Vorteil am gekrümmten Spiegel des Halbleiterkörpers erfolgt. Ein Grundmodenbetrieb des Halbleiterlaserbauelements mit einem planaren externen Spiegel wird so vereinfacht.

Weiterhin kann auf zusätzliche optische Elemente zur Strahlformung im Resonator, etwa Linsen, oder eine Faltung des Resonators zur Reduktion der Strahltaille der Strahlung im Resonator verzichtet werden. Der Resonator kann insbesondere ungefaltet (mit einer ungewinkelten Resonatorachse) ausgeführt sein.

Die aktive Zone kann zur Strahlungserzeugung elektrisch oder optisch gepumpt werden. Im Resonator wird damit durch Verstärkung der Strahlung in der aktiven Zone ein Laserstrahlungsfeld aufgebaut.

In einer bevorzugten Ausgestaltung der Erfindung ist die aktive Zone zur Strahlungserzeugung mittels mindestens einer Pumpstrahlungsquelle, insbesondere eines Pumplasers, optisch gepumpt. Es kann auch eine Mehrzahl von Pumpstrahlungsquellen Anwendung finden.

In einer vorteilhaften Weiterbildung der Erfindung sind die Pumpstrahlungsquelle und der Halbleiterkörper epitaktisch auf einem gemeinsamen Aufwachssubstrat hergestellt. Die Pumpstrahlungsquelle ist bevorzugt als kantenemittierender Halbleiterlaser ausgebildet. Durch eine derartige monolithisch integrierte Ausbildung von Pumpstrahlungsquelle und Halbleiterkörper wird eine vorteilhaft kleine räumliche Ausdehnung des Halbleiterbauelements in Verbindung mit einem effizienten optischen Pumpen des Halbleiterbauelements erzielt. Bevorzugt sind Pumpstrahlungsquelle und Halbleiterkörper lateral nebeneinander angeordnet und die aktive Zone wird im Betrieb des Halbleiterbauelements lateral optisch gepumpt.

In einer weiteren bevorzugten Ausgestaltung der Erfindung enthält der Halbleiterkörper, insbesondere die aktive Zone, mindestens ein III-V-Halbleitermaterial, etwa ein Material aus den Materialsystemen Inₓ Gay Al_{1-x-y} P, Inₓ Gay Al_{1-x-y} As oder Inₓ Gay Al_{1-x-y} N, jeweils mit 0≤x≤1, 0≤y≤1 und x+y≤1. Diese Materialien sind zur effizienten Strahlungserzeugung vom ultravioletten (z.B. Inₓ Gay Al_{1-x-y} N) über den sichtbaren (z.B. Inₓ Gay Al_{1-x-y} P oder Inₓ Gay Al_{1-x-y} N) bis in den infraroten (z.B. Inₓ Gay Al_{1-x-y} As) Spektralbereich besonders geeignet. Weiterhin kann der Halbleiterkörper, insbesondere die aktive Zone, ein Halbleitermaterial aus dem Materialsystem InₓGa₁₋ₓAs_{y}P_{1-y}, mit 0≤x≤1 und 0≤y≤1, enthalten.

In einer weiteren bevorzugten Ausgestaltung der Erfindung ist die aktive Zone zur Strahlungserzeugung im unsichtbaren, insbesondere infraroten, Spektralbereich, ausgebildet.

In einer weiteren bevorzugten Ausgestaltung der Erfindung umfasst die aktive Zone eine Ein- oder Mehrfachquantentopfstruktur. Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

In einer weiteren bevorzugten Ausgestaltung der Erfindung ist im externen Resonator ein nichtlineares optisches Element zur Frequenzkonversion, insbesondere zur Frequenzvervielfachung, etwa zur Frequenzverdoppelung, der in der aktiven Zone erzeugten Strahlung angeordnet. Beispielsweise ist das nichtlineare optische Element ein nicht linearer Kristall geeignet. Vorzugsweise konvertiert das nichtlineare optische Element Strahlung aus dem unsichtbaren Spektralbereich in den sichtbaren Spektralbereich.

Aufgrund des gekrümmten Spiegels kann vereinfacht eine geringe Strahltaille der Strahlung im nichtlinearen optischen Element erzielt werden. Insbesondere kann hierdurch die Effizienz der Frequenzkonversion vorteilhaft erhöht werden. Strahlung im Resonator kann bei geeigneter Ausbildung des gekrümmten Spiegels in dem nichtlinearen optischen Element fokussiert werden. Die Leistungsdichte der Strahlung im nichtlinearen optischen Element kann über Fokussierung erhöht werden, wodurch eine vorteilhaften Erhöhung der Konversionseffizienz der Frequenzkonversion im nichtlinearen optischen Element erreicht wird.

Die Strahltaille der Strahlung im Resonator kann mittels des gekrümmten Spiegels, insbesondere in Kombination mit einem planen ungekrümmten externen Spiegel, seitens des externen Spiegels vorteilhaft gering gehalten werden, wodurch die Frequenzkonversion in der Nähe des externen Spiegels besonders effizient erfolgen kann. Das nichtlineare Optische Element kann an den externen Spiegel angrenzen oder in unmittelbarer Nähe des externen Spiegels angeordnet sein.

In einem erfindungsgemäßen Verfahren zum Herstellen eines Halbleiterbauelements mit einem gekrümmten Halbleiterkörper wird zunächst der Halbleiterkörper bereitgestellt. Der Halbleiterkörper ist auf einem Träger angeordnet. Nachfolgend wird der Halbleiterkörper, vorzugsweise gezielt und/oder definiert, gekrümmt, woraufhin das Halbleiterbauelement fertiggestellt wird. Dabei wird vor dem Krümmen des Halbleiterkörpers ein Fenster im Träger ausgebildet.

Entsprechend diesem Verfahren kann mit Vorteil ein vorgefertigter Halbleiterkörper, insbesondere ein Halbleiterkörper, der auf einem Aufwachssubstrat epitaktisch gewachsen wurde, gezielt gekrümmt werden. Weiterhin kann die Krümmung ohne Abformung des Halbleiterkörpers, das heißt ohne Entfernung von Halbleitermaterial aus dem Halbleiterkörper, erfolgen.

Der Halbleiterkörper wird vorzugsweise in eine vertikale Richtung, senkrecht zu einer lateralen Haupterstreckungsrichtung des Halbleiterkörpers gekrümmt.

Mit Vorzug wird das Verfahren zur Herstellung eines erfindungsgemäßen Halbleiterbauelements eingesetzt, so dass sich die oben und im Folgenden beschriebenen Merkmale des Verfahrens auch auf das Halbleiterbauelement beziehen können und umgekehrt.

In einer bevorzugten Ausgestaltung der Erfindung ist der Halbleiterkörper beim Bereitstellen auf einem Träger angeordnet, der den Halbleiterkörper mechanisch stabilisiert und trägt. Der Träger kann beispielsweise das Aufwachssubstrat, auf dem der Halbleiterkörper epitaktisch gewachsen wurde, umfassen.

Der Träger kann jedoch auch vom Aufwachssubstrat des Halbleiterkörpers verschieden sein. In diesem Falle wird der auf dem Aufwachssubstrat angeordnete Halbleiterkörper beispielsweise seitens der dem Aufwachssubstrat gegenüberliegenden Seite auf einem Träger angeordnet und/oder befestigt, woraufhin das Aufwachssubstrat, beispielsweise über Ätzen oder ein Laserablationsverfahren, vom Halbleiterkörper entfernt werden kann.

Für das Fenster kann der Träger entsprechend abgedünnt oder ausgespart werden. Das Fenster reicht mit Vorzug von der dem Halbleiterkörper abgewandten Seite des Trägers bis zum Halbleiterkörper. Der Träger ist hierfür zweckmäßigerweise im Bereich des Fensters bis zum Halbleiterkörper ausgespart. Beispielsweise wird der Träger zum Ausbilden des Fensters von seiner dem Halbleiterkörper abgewandten Seite her entsprechend strukturiert. Hierzu eignet sich beispielsweise eine geeignete Maskierung, etwa über eine Photolackmaske, in Kombination mit Ätzen, insbesondere nasschemischem Ätzen.

Ist der Träger vom Aufwachssubstrat verschieden, so kann der Träger gegebenenfalls auch vor dem Anordnen des Halbleiterkörpers auf dem Träger entsprechend strukturiert werden.

In einer weiteren bevorzugten Ausgestaltung der Erfindung wird auf den Halbleiterkörper eine Verspannungsschicht als Krümmungselement aufgebracht, die den Halbleiterkörper, insbesondere in einem dem Fenster in vertikaler Richtung nachgeordneten Bereich, über mittels der Verspannungsschicht induzierte Verspannung, etwa Druckverspannung oder Zugverspannung, krümmt. Im Bereich des Fensters ist der Halbleiterkörper einer Krümmung besonders leicht zugänglich, da die Haftung zum Träger bzw. die stabilisierende Wirkung des Trägers in diesem Bereich reduziert bzw. nicht vorhanden ist.

Die Krümmung bzw. der Krümmungsradius des Halbleiterkörpers kann über die Schichtdicke der Verspannungsschicht beeinflusst werden. Je dicker die Verspannungsschicht, desto geringer in der Regel der Krümmungsradius bzw. desto höher in der Regel die Krümmung.

In einer vorteilhaften Weiterbildung der Erfindung enthält die Verspannungsschicht ein Metall, beispielsweise Au, Pt, Cr, Ti oder eine Legierung, insbesondere eine Legierung mit mindestens einem der zuvor genannten Metalle. Geeignete Dicken der Verspannungsschicht können sich im Bereich von 100 nm bis 10 *µ*m bewegen.

In einer weiteren bevorzugten Ausgestaltung der Erfindung wird die Verspannungsschicht auf den Halbleiterkörper gesputtert oder gedampft. Bevorzugt kann über die Prozessparameter, beispielsweise über die Körnung der aufzubringenden Partikel, beim Aufbringen der Verspannungsschicht der Verspannungszustand - etwa druck- oder zugverspannt - und somit die Krümmung - etwa konkav oder konvex - des Halbleiterkörpers eingestellt werden. Eine Druckverspannung bewirkt eher eine von der der Verspannungsschicht gegenüberliegenden Seite des Halbleiterkörpers aus gesehene konvexe Krümmung des Halbleiterkörpers und eine Zugverspannung entsprechend eher eine konkave Krümmung des Halbleiterkörpers.

In einer weiteren bevorzugten Ausgestaltung der Erfindung wird die Verspannungsschicht auf die dem Träger gegenüberliegende Seite des Halbleiterkörpers aufgebracht.

In einer weiteren bevorzugten Ausgestaltung wird die durch die Verspannungsschicht induzierte Krümmung des Halbleiterkörpers mittels einer nachfolgend auf die Verspannungsschicht aufgebrachten Stabilisationsschicht mechanisch stabilisiert. Die Stabilisationsschicht kann beispielsweise galvanisch auf die Verspannungsschicht aufgebracht werden und/oder enthält ein Metall, beispielsweise Cu, Au, Ag oder eine Legierung, insbesondere mit mindestens einem dieser Metalle. Bevorzugt ist die Stabilisationsschicht verglichen mit der Verspannungsschicht dick ausgebildet und weist beispielsweise eine Dicke von zum Beispiel 100 *µ*m oder weniger auf, wobei die Dicke jedoch so groß ist, dass die Krümmung des Halbleiterkörpers stabilisiert wird. Die Stabilisationsschicht kann im an den Halbleiterkörper angrenzenden Bereich entsprechend der Krümmung des Halbleiterkörpers gekrümmt sein.

Weiterhin weist die Stabilisationsschicht mit Vorteil eine hohe Wärmeleitfähigkeit auf, wodurch eine gute thermische Anbindung des Halbleiterkörpers über die Verspannungs- und die Stabilisationsschicht an einen Kühlkörper, auf dem die Stabilisationsschicht angeordnet sein kann, erzielt wird. Die oben genannten Metalle, insbesondere Cu oder Ag, und auf diesen basierende Legierungen weisen besonders hohe Wärmeleitfähigkeiten und sind auch zur Krümmungsstabilisation gut geeignet.

In einer weiteren bevorzugten Ausgestaltung der Erfindung wird dem Halbleiterkörper ein Formelement als Krümmungselement nachgeordnet. Das Formelement weist vorzugsweise einen gemäß der gewünschten Krümmung des Halbleiterkörpers geformten Bereich auf, an den sich der Halbleiterkörper insbesondere in den mit dem Fenster überlappenden Bereich andrückt oder der an den Halbleiterkörper angedrückt wird. Die Krümmung des Halbleiterkörpers wird durch die Formgebung des in dem Formelement geformten Bereichs bestimmt. Die Krümmung wird gegebenenfalls durch leichten, den Halbleiterkörper nicht schädigenden, mittels des Formelements auf den Halbleiterkörper ausgeübten Drucks erzeugt und/oder über die Formgebung des Formelements stabilisiert. Das Formelement ist zweckmäßigerweise zugleich als Wärmesenke ausgebildet.

In einer weiteren bevorzugten Ausgestaltung der Erfindung wird der Halbleiterkörper mittels eines über ein Druckelement, vorzugsweise vorübergehend, auf den Halbleiterkörper ausgeübten Drucks gekrümmt. Bevorzugt wird die durch den Druck erzeugte Krümmung mittels einer Stabilisationsschicht, etwa einer metallhaltigen Schicht, die besonders bevorzugt während der Druckausübung auf den Halbleiterkörper auf diesen aufgebracht wird, derart stabilisiert, dass der Halbleiterkörper mit Vorteil auch nach beendeter Druckausübung gekrümmt ist. Der Druck kann als Gasdruck, etwa über eine Pumpe oder ein Gebläse, oder als hydrodynamischer Druck, etwa über eine Flüssigkeit, mittels des Druckelements auf den Halbleiterkörper ausgeübt werden. Vorzugsweise wird der Druck derart auf den Halbleiterkörper ausgeübt, dass der Halbleiterkörper in einem, insbesondere mit dem Fenster des Trägers überlappenden, Teilbereich gekrümmt wird, ein verbleibender Teilbereich des Halbleiterkörpers jedoch weiterhin eben verläuft.

In einer weiteren bevorzugten Ausgestaltung kann mittels des erfindungsgemäßen Verfahrens gleichzeitig eine Mehrzahl von Halbleiterbauelementen mit gekrümmtem Halbleiterkörper im Waferverbund hergestellt werden. Beispielsweise wird hierfür eine auf einer Trägerschicht angeordnete Halbleiterschichtenfolge, die für die Ausbildung einer Mehrzahl von, vorzugsweise gleichartigen, Halbleiterkörpern vorgesehen ist, in einer Mehrzahl von Teilbereichen entsprechend dem oben beschriebenen Verfahren gekrümmt.

Ist die Halbleiterschichtenfolge für Halbleiterkörper für Halbleiterlaserbauelemente mit externem Resonator ausgebildet, so kann dem Verbund eine, vorzugsweise ebene, externe Spiegelschicht, die für eine Mehrzahl von externen Spiegeln vorgesehen ist, nachgeordnet werden. Bevorzugt kann die Spiegelschicht bereits im Verbund in vertikaler Richtung relativ zur Halbleiterschichtenfolge justiert werden.

Einzelne Halbleiterbauelemente können aus dem Verbund durch Vereinzeln gewonnen werden.

Weitere Vorteile, vorteilhafte Weiterbildungen und Zweckmäßigkeiten der Erfindung ergeben sich aus der Beschreibung der folgenden Ausführungsbeispiele in Verbindung mit den Figuren.

Es zeigen:
Figuren 1, 2 und 3 ein erstes Ausführungsbeispiel eines erfindungsgemäßen Verfahrens anhand von in den Figuren 1, 2 und 3 in Schnittansichten schematisch dargestellten Zwischenschritten,
Figuren 1, 2, 4A und 4B ein zweites Ausführungsbeispiel eines erfindungsgemäßen Verfahrens anhand von in den Figuren 1, 2, 4A und 4B in Schnittansichten schematisch dargestellten Zwischenschritten,
Figur 5 ein erstes Ausführungsbeispiel eines erfindungsgemäßen Halbleiterbauelements anhand einer schematischen Schnittansicht,
Figur 6 ein zweites Ausführungsbeispiel eines erfindungsgemäßen Halbleiterbauelements anhand einer schematischen Schnittansicht,
Figur 7 ein drittes Ausführungsbeispiel eines erfindungsgemäßen Halbleiterbauelements anhand einer schematischen Schnittansicht und
Figur 8 ein viertes Ausführungsbeispiel eines erfindungsgemäßen Halbleiterbauelements anhand einer schematischen Schnittansicht.

Gleiche, gleichartige oder gleichwirkende Elemente sind in den Figuren mit den gleichen Bezugszeichen versehen.

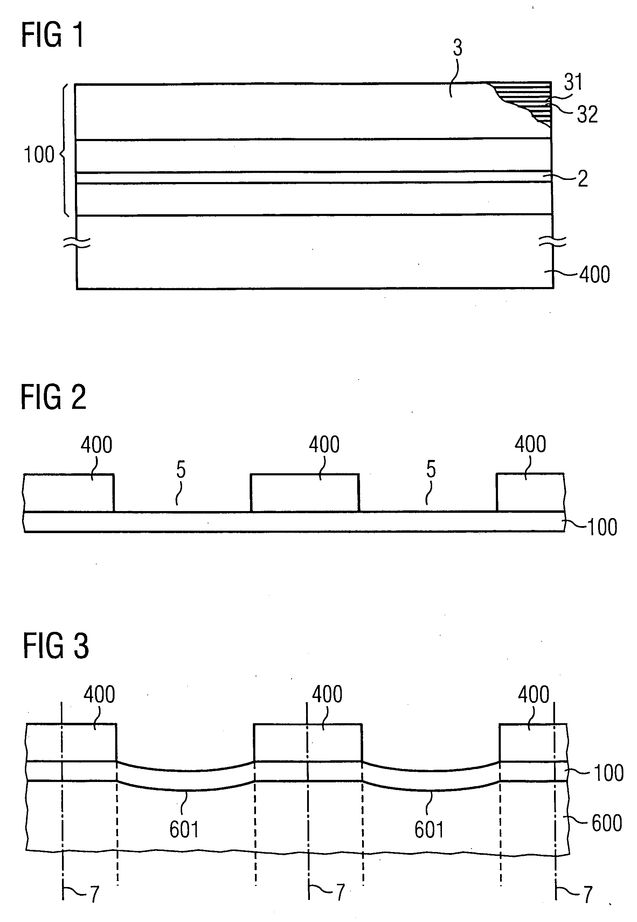

In den Figuren 1 bis 3 ist ein erstes Ausführungsbeispiel eines erfindungsgemäßen Verfahrens anhand von in den Figuren gezeigten Zwischenschritten schematisch dargestellt.

Zunächst wird wie in Figur 1 gezeigt eine auf einer Trägerschicht 400 angeordnete Halbleiterschichtenfolge 100, die eine zur Strahlungserzeugung vorgesehene aktive Zone 2 und eine Spiegelstruktur 3 umfasst, bereitgestellt. Die Spiegelstruktur 3 ist mit der aktiven Zone 2 monolithisch in der Halbleiterschichtenfolge integriert.

Die Trägerschicht 400 ist beispielsweise durch das Aufwachssubstrat, auf dem die Halbleiterschichtenfolge epitaktisch aufgewachsen wurde, gegeben oder kann das Aufwachssubstrat umfassen. Gegebenenfalls kann die Trägerschicht jedoch auch vom Aufwachssubstrat verschieden sein. Die Halbleiterschichtenfolge 100 weist eine laterale Haupterstreckungsrichtung entlang der Trägerschicht 400 auf und ist, wie üblicherweise nach einem herkömmlichen Epitaxieverfahren, im wesentlichen ungekrümmt und eben ausgebildet.

Die Spiegelstruktur 3 ist gemäß einem Bragg-Spiegel ausgebildet und umfasst hierzu eine Mehrzahl von Halbleiterschichtenpaaren, die jeweils eine erste Schicht 31 und eine zweite Schicht 32, deren Brechungsindexunterschied vergleichsweise hoch ist, aufweisen und als λ/4-Schichten für in der aktiven Zone 2 erzeugte Strahlung ausgeführt. Über die Anzahl der Halbleiterschichtenpaare wird die Reflektivität des Bragg-Spiegels bestimmt.

Beispielsweise ist die aktive Zone 2 zur Strahlungserzeugung im infraroten Spektralbereich ausgebildet. Hierzu basiert die Halbleiterschichtenfolge bevorzugt auf dem III-V-Halbleitermaterialsystem Inₓ Gay Al_{1-x-y} As, mit 0≤x≤1, 0≤y≤1 und x+y≤1. Als Trägerschicht 400 bzw. Aufwachssubstrat ist hierbei GaAs besonders geeignet. Die Halbleiterschichtenpaare umfassen hierbei beispielsweise eine AlGaAs-Schicht als erste 31 und eine GaAs-Schicht als zweite Schicht.

Die aktive Zone kann beispielsweise als Ein- oder Mehrfachquantentopfstruktur ausgebildet sein. Derartige Strukturen sind zur effizienten Strahlungserzeugung in der aktiven Zone besonders geeignet.

Die Halbleiterschichtenfolge 100 des in Figur 1 dargestellten Waferverbunds mit der Halbleiterschichtenfolge und der Trägerschicht 400 ist zur Herstellung einer Mehrzahl von Halbleiterkörpern, die aus Teilbereichen der Halbleiterschichtenfolge hervorgehen, vorgesehen.

Nachfolgend wird die Trägerschicht 400, vorzugsweise von der der Halbleiterschichtenfolge gegenüberliegenden Seite her derart strukturiert, dass eine Mehrzahl von der der Halbleiterschichtenfolge gegenüberliegenden Seite der Trägerschicht bis zur Halbleiterschichtenfolge reichenden Fenstern 5 in der Trägerschicht ausgebildet wird. Die resultierende Struktur ist in Figur 2 anhand einer Schnittansicht schematisch dargestellt. Auf eine Darstellung der Einzelelemente der Halbleiterschichtenfolge (z.B. Spiegelstruktur und aktive Zone) wird in Figur 2 und den folgenden Figuren aus Gründen der Übersichtlichkeit verzichtet.

Die Fenster 5 können beispielsweise über geeignete Maskierung und Ätzen von der der Halbleiterschichtenfolge gegenüberliegenden Seite her in die Trägerschicht strukturiert werden. Beispielsweise sind hierfür photolithographische Methoden mit einer Photolackmaske, nasschemischem Ätzen der Trägerschicht und nachfolgendem Entfernen der Photolackmaske geeignet.

Nach dem in Figur 2 gezeigten Zwischenschritt werden in einem ersten Ausführungsbeispiel des erfindungsgemäßen Verfahrens gemäß Figur 3 mittels eines Formelements 600, an das sich die Halbleiterschichtenfolge andrückt und das ein Mehrzahl von entsprechend der gewünschten Krümmung der Halbleiterschichtenfolge vorgeformten, gekrümmten Teilbereichen 601 aufweist, die mit den Fenstern überlappenden Teilbereiche der Halbleiterschichtenfolge gezielt gekrümmt. Die Krümmung wird hierbei durch die Ausgestaltung des Formelements bestimmt.

Das Formelement 600 wird mit Vorzug mit einer derart geringen Kraft an die Halbleiterschichtenfolge 100 angedrückt, dass sich die Halbleiterschichtenfolge in Teilbereichen krümmt, die Halbleiterschichtenfolge, insbesondere die aktive Zone jedoch für eine Strahlungserzeugung funktionsfähig bleiben. Außerhalb der vorgeformten Teilbereiche verläuft die Halbleiterschichtenfolge mit Vorzug weiterhin eben.

Das Formelement ist zweckmäßigerweise zugleich als Wärmesenke ausgebildet und enthält zum Beispiel ein Metall oder eine Legierung, etwa CuWo, so dass bei Strahlungserzeugung in der aktiven Zone anfallende Wärme vereinfacht abgeführt werden kann. Nachfolgend kann, entlang von Linien 7 in Halbleiterbauelemente vereinzelt werden, die jeweils einen monolithisch in einem Halbleiterkörper, der beim Vereinzeln aus der Halbleiterschichtenfolge hervorgeht, integrierten gekrümmten Spiegel, der aus der Spiegelstruktur beim Vereinzeln hervorgeht, umfassen. Das Vereinzeln kann beispielsweise über Sägen oder Lasertrennen erfolgen.

In einem zweiten Ausführungsbeispiel eines erfindungsgemäßen Verfahrens zur Herstellung eines Halbleiterbauelements mit einem gekrümmten Halbleiterkörper das in den Figuren 1,2, 4A und 4B schematisch dargestellt ist, wird zunächst gemäß in Figur 1 und Figur 2 und im Zusammenhang mit diesen Figuren bereits erläutert vorgegangen. Nachfolgend wird auf die der Trägerschicht 400 gegenüberliegende Seite der Halbleiterschichtenfolge 100 eine Verspannungsschicht 800, vorzugsweise vollflächig, aufgebracht. Die Verspannungsschicht wird mit Vorzug auf die Halbleiterschichtenfolge 100 aufgedampft oder aufgesputtert und enthält beispielsweise Au.

Die Verspannungsschicht induziert eine Verspannung in den Bereichen der Halbleiterschichtenfolge, die mit den Fenstern 5 überlappen, da in diesen Teilbereichen die Halbleiterschichtenfolge nicht durch Haftung an der Trägerschicht mechanisch stabilisiert ist und einer Verformung somit vereinfacht zugänglich ist.

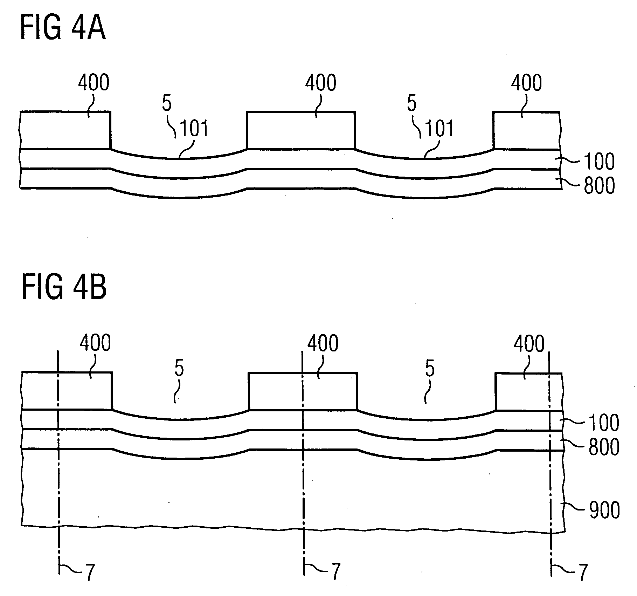

Über die Prozessparameter beim Aufbringen der Verspannungsschicht kann die Verspannung des Halbleiterkörpers und hierüber die Krümmung - konvex gekrümmt oder wie dargestellt vom Fenster bzw. der der Verspannungsschicht gegenüberliegenden Seite der Halbleiterschichtenfolge aus gesehen konkav gekrümmt - beeinflusst werden. Eine wie in Figur 4 dargestellte konkave Krümmung kann mittels einer Zugverspannung, die durch die Verspannungsschicht kontrolliert erzeugt wird, erzielt werden.

Der Krümmungsradius der im Bereich der Fenster 5 gekrümmten Teilbereiche 101 der Halbleiterschichtenfolge 100 kann über die Dicke der Verspannungsschicht 800 beeinflusst werden, wobei mit wachsender Dicke der Krümmungsradius in der Regel abnimmt. Beispielsweise kann die Halbleiterschichtenfolge derart gekrümmt werden, dass in den gekrümmten Teilbereichen ein gekrümmter, insbesondere konkaver, Spiegel mit einer Brennweite von 2 bis 20 mm ausgebildet wird.

Vorzugsweise sind die gekrümmten Teilbereiche der Halbleiterschichtenfolge gleichartig gekrümmt.

Die nach dem Aufbringen der Verspannungsschicht 800 resultierende Struktur ist anhand einer schematischen Schnittansicht in Figur 4A dargestellt.

In einem weiteren Verfahrensschritt kann die Krümmung über eine nachfolgend auf die Verspannungsschicht aufgebrachte Stabilisationsschicht 900 stabilisiert werden. Die Stabilisationsschicht enthält mit Vorzug ein Metall, etwa Cu, weist eine hohe Wärmeleitfähigkeit auf und/oder wird galvanisch auf die metallhaltige Verspannungsschicht 800 aufgebracht.

Nachfolgend kann entlang der Linien 7 in Halbleiterbauelemente, die jeweils einen Halbleiterkörper mit einem monolithisch in den Halbleiterkörper integrierten, gekrümmten, Bragg-Spiegel aufweisen, vereinzelt werden.

Über die anhand der Figuren 1 bis 4B erläuterten Verfahren kann eine vorgefertigte Halbleiterschichtenfolge bzw. ein einzelner Halbleiterkörper kostengünstig, gezielt und definiert gekrümmt werden.

Alternativ oder ergänzend zu den obigen Verfahren kann die Halbleiterschichtenfolge mittels eines über ein Druckelement auf die Halbleiterschichtenfolge ausgeübten Drucks gekrümmt werden. Beispielsweise wird hierzu mittels einem Gebläse bzw einer Pumpe ein Über- oder Unterdruck von der der Trägerschicht gegenüberliegenden Seite der Halbleiterschichtenfolge her oder durch die Fenster in der Trägerschicht auf die Halbleiterschichtenfolge ausgeübt, die sich aufgrund des ausgeübten Drucks, insbesondere in den mit den Fenstern überlappenden Teilbereichen, entsprechend gezielt krümmt.

Beispielsweise kann hierzu jedem zu krümmenden Teilbereich ein Kanal der Pumpe bzw. des Gebläses zugeordnet sein, so dass der Druck über die Kanäle gezielt und örtlich begrenzt auf die zu krümmenden Teilbereiche der Halbleiterschichtenfolge ausgeübt wird, die nicht zu krümmenden Teilbereiche nur einen entsprechend geringeren Druck erfahren und so mit Vorzug weiterhin eben verlaufen.

Eine ortsaufgelöste Druckausübung auf die Halbleiterschichtenfolge kann gegebenenfalls auch von der der Halbleiterschichtenfolge gegenüberliegenden Seite der Trägerschicht durch die Fenster der Trägerschicht erfolgen. Bevorzugt dienen die Fenster aufgrund der hohen Stabilität der Trägerschicht als "Kanäle", wodurch die Halbleiterschichtenfolge in den mit den Fenstern überlappenden Teilbereichen gekrümmt wird. Insbesondere kann so mit Vorteil ein gleichmäßiger, ortsunabhängiger Druck auf die Trägerschicht ausgeübt werden, der die Halbleiterschichtenfolge in den mit den Fenstern überlappenden Teilbereichen und damit ortsaufgelöst krümmt, wobei die verbleibenden Teilbereiche aufgrund der vergleichsweise hohen Stabilität der dem gleichmäßigen Druck entgegenwirkenden Trägerschicht mit Vorzug weiterhin eben verlaufen.

Gegebenenfalls kann auch von der der Trägerschicht gegenüberliegenden Seite der Halbleiterschichtenfolge ein gleichmäßiger Druck auf die Halbleiterschichtenfolge ausgeübt werden, wobei sich die Halbleiterschichtenfolge in den mit den Fenstern überlappenden Teilbereichen aufgrund der im Bereich der Fenster verringerten Haftung an der Trägerschicht krümmt, in den verbleibenden Teilbereichen jedoch, aufgrund der stabilisierenden, dem Druck entgegenwirkenden Haftung an der Trägerschicht, vorzugsweise weiterhin eben verläuft.

Die durch den Druck erzeugte Krümmung kann mittels einer während der Druckausübung auf die Halbleiterschichtenfolge aufgebrachten Stabilisationsschicht, etwa ähnlich einer vergleichsweise dicken metallhaltigen Stabilisationsschicht der oben genannten Art, stabilisiert werden, so dass die Halbleiterschichtenfolge auch nach beendeter Druckausübung zumindest in Teilbereichen gekrümmt ist. Die Stabilisationsschicht kann auf die Halbleiterschichtenfolge beispielsweise aufgedampft oder aufgesputtert werden. Je größer der Druck, desto größer in der Regel die Krümmung. Der Druck kann gegebenenfalls, insbesondere ortsaufgelöst oder gleichmäßig, mittels einer Flüssigkeit, die zur Druckausübung vorzugsweise direkt mit der Halbleiterschichtenfolge in Kontakt tritt, auf die Halbleiterschichtenfolge ausgeübt werden.

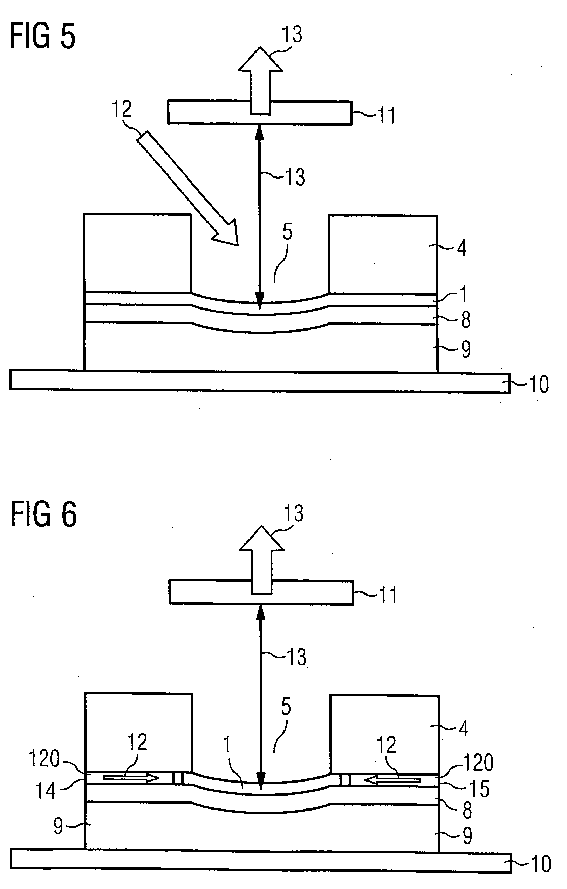

In Figur 5 ist ein erstes Ausführungsbeispiel eines erfindungsgemäßen Halbleiterbauelements anhand einer schematischen Schnittansicht dargestellt. Beispielsweise kann ein Halbleiterbauelement gemäß Figur 5 unter Anwendung des Verfahrens nach den Figuren 1, 2, 4A und 4B hergestellt werden.

Ein Halbleiterkörper 1, der eine zur Strahlungserzeugung vorgesehene aktive Zone (nicht dargestellt) aufweist, ist auf einem Träger 4 angeordnet, der im Bereich eines Fensters 5 ausgespart ist. Im Halbleiterkörper monolithisch integriert ist auf der dem Träger 4 abgewandten Seite der aktiven Zone ein Bragg-Spiegel (nicht dargestellt), der im mit dem Fenster 5 überlappenden Bereich gezielt gekrümmt ist. Dem Bragg-Spiegel nachgeordnet ist eine Verspannungsschicht 8, die beispielsweise eine die Krümmung hervorrufende Zugspannung am Halbleiterkörpers erzeugt, die in einer vom Fenster aus gesehen konkaven Krümmung des Halbleiterkörpers im mit dem Fenster überlappenden Bereich resultiert.

Über die Stabilisationsschicht 9 wird die Krümmung bzw. der Krümmungsradius des Halbleiterkörpers stabilisiert und der Halbleiterkörper vorzugsweise wärmeleitend mit einem externen Kühlkörper 10, etwa Cu enthaltend, verbunden, auf dem die Stabilisationsschicht vorzugsweise angeordnet ist. Die Struktur mit dem Träger, dem Halbleiterkörper, der Verspannungsschicht und der Stabilisationsschicht kann beispielsweise beim Vereinzeln aus der in Figur 4B gezeigten Struktur hervorgehen.

Der Halbleiterkörper 1 weist im Bereich des Fensters einen gekrümmten Teilbereich auf und verläuft außerhalb des gekrümmten Teilbereichs und lateral an diesen angrenzend im wesentlichen eben zur Oberfläche des Trägers.

Dem Halbleiterkörper 1 ist ein externer Spiegel 11 nachgeordnet, der in diesem Ausführungsbeispiel eben ausgeführt ist, und zusammen mit dem im Halbleiterkörper 1 integrierten Bragg-Spiegel einen externen, vorzugsweise geraden oder ungefalteten, Resonator für eine in der aktiven Zone erzeugte Strahlung 13 bildet.

Zwischen den beiden Spiegeln kann sich ein Strahlungsfeld aufbauen, welches durch stimulierte Emission in der aktiven Zone zu Laserstrahlung verstärkt werden kann.

Zur Strahlungserzeugung wird die aktive Zone mittels eines externen Pumplasers, der eine Pumpstrahlung 12 erzeugt, die eine Wellenlänge kleiner der in der aktiven Zone zu erzeugenden Strahlung aufweist, optisch gepumpt. Die Pumpstrahlung 12 wird in der aktiven Zone absorbiert und als Strahlung 13 einer größeren Wellenlänge, etwa im Infraroten, reemittiert. Strahlung kann seitens des vorzugsweise als Auskoppelspiegel ausgebildeten externen Spiegels 11 aus dem Resonator ausgekoppelt werden.

Das Halbleiterbauelement ist in diesem Ausführungsbeispiel als Halbleiterlaserbauelement mit externem Resonator (VECSEL oder Halbleiterscheibenlaser) ausgebildet. Die Strahlformung der Strahlung im Resonator erfolgt im Wesentlichen ausschließlich über den gekrümmten Bragg-Spiegel im Halbleiterkörper. Bevorzugt ist das Halbleiterlaserbauelement in der Grundmode, etwa der Gaußschen Grundmode TEM₀₀, betreibbar. Eine Brennweite des gekrümmten Bragg-Spiegels liegt beispielsweise zwischen 2 und 20 mm.

Auf weitergehende optische Elemente, insbesondere gekrümmte und damit vergleichsweise kostenintensive optische Elemente, zur Strahlformung im Resonator kann mit Vorteil verzichtet werden.

Zur Herstellung derartiger Halbleiterlaserbauelemente kann zum Beispiel im Waferverbund gemäß den Figuren 4A und 4B eine gezielte Krümmung des Halbleiterkörpers beziehungsweise der Halbleiterschichten in Teilbereichen, die zur Ausbildung von Halbleiterkörpern vorgesehen sind, erzeugt werden.

Der Struktur aus Figur 4B kann eine externe Spiegelschicht, die zur Ausbildung einer Mehrzahl von externen Spiegeln vorgesehen und vorzugsweise plan ausgeführt ist nachgeordnet werden. Der vertikale Abstand zum Halbleiterkörper beziehungsweise der aktiven Zone und Spiegelschicht kann über Abstandhalter die beispielsweise auf der der Halbleiterschichtenfolge gegenüberliegenden Seite der Trägerschicht angeordnet sind, eingestellt werden. Die Justage des planen externen Spiegels relativ zur aktiven Zone kann so mit Vorteil auf einfache Weise und bereits im Waferverbund durchgeführt werden.

Weiterhin können über eine Krümmung des im Halbleiterkörper integrierten Bragg-Spiegels kurze Resonatoren, insbesondere mit einer Resonatorlänge von weniger als 5 mm, für einen effizienten Laserbetrieb vereinfacht verwirklicht werden. Im Pulsbetrieb werden so hohe Modulationsfrequenzen - die zeitliche Abfolgefrequenz von Pulsen - von mehr als 50 MHz vereinfacht zugänglich, da verkürzte Resonatorlängen das Erreichen höherer Modulationsfrequenzen erleichtern.

In Figur 6 ist ein zweites Ausführungsbeispiel eines erfindungsgemäßen Halbleiterbauelements anhand einer Schnittansicht schematisch dargestellt. Im Wesentlichen entspricht das in Figur 6 gezeigte Bauelement dem in Figur 5 gezeigten. Im Unterschied zur Figur 5 ist die aktive Zone in Figur 6 nicht mittels eines externen Pumplasers optisch gepumpt, sondern die Pumpstrahlungsquelle und der Halbleiterkörper sind auf gemeinsamen Substrat, vorzugsweise epitaktisch auf einem Aufwachssubstrat, hergestellt.

Hierzu wird beispielsweise zuerst eine Halbleiterschichtenfolge für den oberflächenemittierenden Halbleiterkörper auf einem Substrat gewachsen, nachfolgend werden Teilbereiche der Halbleiterschichtenfolge entfernt und in den entfernten Bereichen kann die Pumpstrahlungsquelle epitaktisch auf dem Substrat hergestellt werden. Die Pumpstrahlungsquelle und der Halbleiterkörper können insbesondere monolithisch integriert sein. Hierbei ist als Pumpstrahlungsquelle ein kantenemittierender Halbleiterlaser besonders geeignet.

Die Pumpstrahlung 12 koppelt beispielsweise aus einer Mehrzahl von Pumpstrahlungsquellen 120 aus lateraler Richtung in die aktive Zone des Halbleiterkörpers 1 ein. Der Halbleiterkörper kann, wie dargestellt, zwischen zwei Pumpstrahlungsquellen angeordnet sein oder mit einem Resonator einer Pumpstrahlungsquelle 120 überlappen.
Ein Resonator der Pumpstrahlungsquelle kann lateral beispielsweise durch eine erste Seitenfläche 14 und eine zweite Seitenfläche 15 begrenzt werden, die als Spiegelflächen ausgebildet sein können. Derartige Seitenflächen können beispielsweise beim Vereinzeln etwa durch geeignetes Spalten im Waferverbund aus den für die Pumpstrahlungsquellen hergestellten Strukturen hervorgehen.

Die aktive Zone des Halbleiterkörpers wird in diesem Ausführungsbeispiel lateral durch einen monolithisch integrierten kantenemittierenden Pumplaser optisch gepumpt.

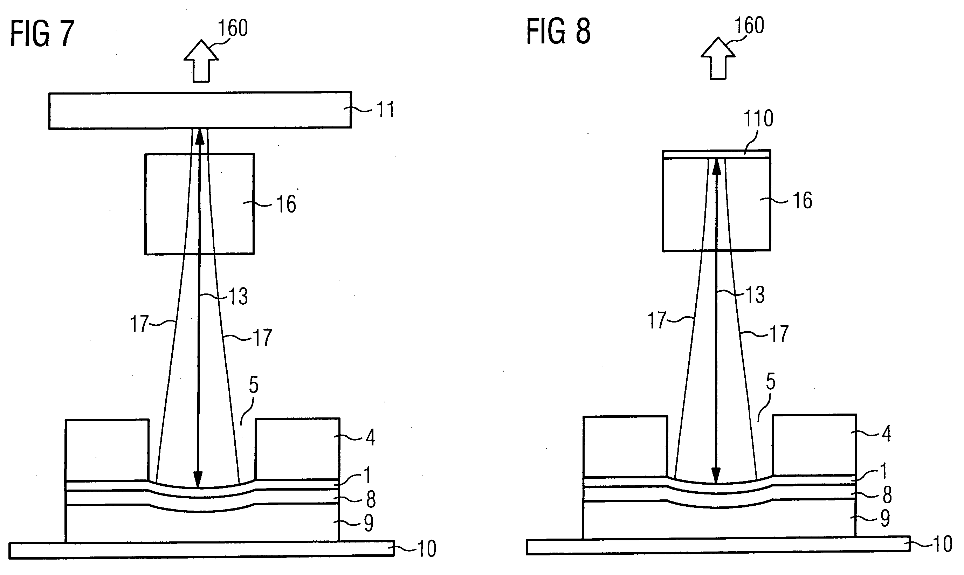

In Figur 7 ist ein drittes Ausführungsbeispiel eines erfindungsgemäßen Halbleiterbauelements anhand einer Schnittansicht schematisch dargestellt. Im Wesentlichen entspricht das Halbleiterbauelement einem in Figur 5 oder Figur 6 gezeigten Bauelement. Entsprechend kann die aktive Zone lateral monolithisch integriert oder extern optisch gepumpt werden.

Im Unterschied zu den vorhergehenden Ausführungsbeispielen ist im externen Resonator ein nichtlineares optisches Element 16, etwa ein nichtlinearer optischer Kristall, wie BiBo (Wismuthtriborat), zur Frequenzkonversion angeordnet. In der aktiven Zone durch optisches Pumpen oder induzierte Emission erzeugte bzw. verstärkte Strahlung kann im nicht linearen optischen Element 16 in der Frequenz verdoppelt (SHG: Second Harmonic Generation) werden, so dass sich beispielsweise aus nicht sichtbarer, etwa infraroter, Strahlung sichtbare, etwa grüne oder blaue, Strahlung ergibt.

Frequenzkonvertierte Strahlung 160 kann über den externen Spiegel aus dem Resonator ausgekoppelt werden. Hierzu ist der externe Spiegel vorzugsweise hochtransmittiv für die frequenzkonvertierte Strahlung 160 und hochreflektiv für die nicht konvertierte Strahlung ausgebildet. Um die Effizienz der Frequenzkonversion zu erhöhen bzw. die Resonatorverluste gering zu halten, kann das nichtlineare optische Element Strahlungseintritts- und/oder -austrittsseitig mit Antireflexbeschichtungen versehen sein.

Aufgrund des gekrümmten Spiegels im Halbleiterkörper und des planen externen Spiegels kann mit einem geraden, ungefalteten Resonator seitens des externen Spiegels ein vorteilhaft geringe Strahltaille, wie in Figur 7 anhand der Linien 17 angedeutet ist, erzielt werden. Auf eine Faltung, etwa gemäß einem Z- oder W-Resonator kann ebenso wie auf gekrümmte optische Elemente mit Vorteil verzichtet werden. Derartige Maßnahmen können resonatorinterne Verluste, beispielsweise über Streuungs-, Beugungs-, Reflexions- oder Absorptionsverluste, erhöhen und sind vergleichsweise kostenintensiv.

Das nichtlineare optische Element 16 kann insbesondere im Fokus des gekrümmten Spiegels angeordnet sein, so dass aufgrund der mittels Fokussierung im nichtlinearen optischen Element erhöhten Leistungsdichte die Effizienz der Frequenzkonversion erhöht wird.

Weiterhin ist die aktive Zone im Resonator mit Vorzug gemäß einer RPG-Struktur angeordnet (RPG: Resonant Periodic Gain). Dies bedeutet, dass die aktive Zone, etwa deren Quantentopfstruktur, derart im Resonator angeordnet ist, dass sie mit einem Wellenbauch einer sich im Resonator ausbildenden stehenden Welle überlappt, so dass die Verstärkung in der aktiven Zone besonders effizient erfolgen kann.

In einer beispielhaften Dimensionierung des Resonators ist die Resonatorlänge ungefähr 10 mm und der Abstand des tiefsten Punkts des gekrümmten Spiegels vom Träger 1 *µ*m.

In Figur 8 ist ein viertes Ausführungsbeispiel eines erfindungsgemäßen Halbleiterbauelements anhand einer Schnittansicht schematisch dargestellt. Das Ausführungsbeispiel in Figur 8 entspricht im Wesentlichen dem in Figur 7 gezeigten, im Unterschied hierzu ist auf einen separaten externen Spiegel 11 verzichtet. Der Spiegel 11 ist hier vielmehr als Beschichtung auf dem nichtlinearen optischen Element insbesondere dessen der aktiven Zone abgewandten Seite ausgebildet. Hierdurch kann eine weitergehende Verringerung der Strahltaille im nichtlinearen optischen Element erzielt werden. Die Beschichtung 110 seitens der Lichtaustrittsseite aus dem Resonator ist vorzugsweise hochreflektiv für die Wellenlänge der in der aktiven Zone erzeugten Strahlung 13 und vorzugsweise hochtransmittiv für die frequenzkonvertierte Strahlung 160.

## Patentansprüche

1. Halbleiterbauelement mit einem Halbleiterkörper (1), wobei
der Halbleiterkörper einen gekrümmten Spiegel (3) umfasst, der monolithisch im Halbleiterkörper integriert ist, und der Halbleiterkörper (1) auf einem Träger (4,400) angeordnet ist,
**dadurch gekennzeichnet, dass**
ein die Krümmung induzierendes oder formendes Krümmungselement (600,800,8) auf der dem Träger (4,400) abgewandten Seite des Halbleiterkörpers (1) angeordnet ist, wobei das Krümmungselement auf den Halbleiterkörper auf der dem Träger abgewandten Seite aufgebracht oder dem Halbleiterkörper auf der dem Träger abgewandten Seite nachgeordnet ist.

2. Halbleiterbauelement nach Anspruch 1,
**dadurch gekennzeichnet, dass**
der Halbleiterkörper (1) und der gekrümmte Spiegel (3) eine gleichartige Krümmung aufweisen.

3. Halbleiterbauelement nach Anspruch 1 oder 2,
**dadurch gekennzeichnet, dass**
der gekrümmte Spiegel (3) ein Bragg-Spiegel ist.

4. Halbleiterbauelement nach einem der vorhergehenden Ansprüche,
**dadurch gekennzeichnet, dass**
der Träger (4,400) eben ist.

5. Halbleiterbauelement nach einem der vorhergehenden Ansprüche,
**dadurch gekennzeichnet, dass**
der Halbleiterkörper (1) mindestens einen für den gekrümmten Spiegel (3) gekrümmten Teilbereich und mindestens einen ebenen Teilbereich aufweist.

6. Halbleiterbauelement nach Anspruch 5,
**dadurch gekennzeichnet, dass**
dem gekrümmten Teilbereich in vertikaler Richtung ein Fenster (5), in dem der Träger (4,400) abgedünnt oder ausgespart ist, nachgeordnet ist.

7. Halbleiterbauelement nach Anspruch 6,
**dadurch gekennzeichnet, dass**
der gekrümmte Teilbereich in vertikaler Richtung mit dem Fenster (5), vorzugsweise vollständig, überlappt.

8. Halbleiterbauelement nach einem der vorhergehenden Ansprüche,
**dadurch gekennzeichnet, dass**
das Krümmungselement (600,800,8) eine auf den Halbleiterkörper (1) aufgebrachte metallhaltige Verspannungsschicht (800,8) ist.

9. Halbleiterbauelement nach einem der vorhergehenden Ansprüche,
**dadurch gekennzeichnet, dass**
der Halbleiterkörper (1) eine zur Strahlungserzeugung vorgesehene aktive Zone (2) aufweist.

10. Halbleiterbauelement nach Anspruch 9,
**dadurch gekennzeichnet, dass**
das Halbleiterbauelement ein oberflächenemittierendes Halbleiterbauelement ist.

11. Halbleiterbauelement nach Anspruch 9 oder 10,
**dadurch gekennzeichnet, dass**
das Halbleiterbauelement zur Erzeugung von Laserstrahlung (13) mittels eines externen Resonators vorgesehen ist und es für den externen Resonator vorgesehen ist, der aktiven Zone (2) einen externen Spiegel (11) nachzuordnen.

12. Halbleiterbauelement nach Anspruch 11,
**dadurch gekennzeichnet, dass**
der externe Spiegel (11) eben ausgeführt ist.

13. Halbleiterbauelement nach einem der Ansprüche 9 bis 12, **dadurch gekennzeichnet, dass**
die aktive Zone (2) zur Strahlungserzeugung mittels mindestens einer Pumpstrahlungsquelle (120), insbesondere eines Pumplasers, optisch gepumpt ist.

14. Halbleiterbauelement nach Anspruch 13,
**dadurch gekennzeichnet, dass**
die Pumpstrahlungsquelle (120) und der Halbleiterkörper (1) auf einem gemeinsamen Aufwachssubstrat monolithisch integriert sind.

15. Halbleiterbauelement nach einem der Ansprüche 9 bis 14,
**dadurch gekennzeichnet, dass**
im externen Resonator ein nichtlineares optisches Element (16) zur Frequenzkonversion, insbesondere zur Frequenzvervielfachung, der in der aktiven Zone erzeugten Strahlung (13), angeordnet ist.

16. Halbleiterbauelement nach einem der vorhergehenden Ansprüche,
**dadurch gekennzeichnet, dass**
der Träger (4,400) das Aufwachssubstrat, auf dem der Halbleiterkörper (1,100) epitaktisch gewachsen ist, umfasst.

17. Verfahren zum Herstellen eines Halbleiterbauelements mit einem gekrümmten Halbleiterkörper,
mit den Schritten
a) Bereitstellen eines Halbleiterkörpers (1,100), der auf einem Träger (4,400) angeordnet ist,
b) Krümmen des Halbleiterkörpers, wobei ein die Krümmung induzierendes oder formendes Krümmungselement (600,800,8) auf der dem Träger (4,400) abgewandten Seite des Halbleiterkörpers (1) angeordnet wird, und wobei das Krümmungselement auf den Halbleiterkörper auf der dem Träger abgewandten Seite aufgebracht oder dem Halbleiterkörper auf der dem Träger abgewandten Seite nachgeordnet wird,
c) Fertigstellen des Halbleiterbauelements **dadurch gekennzeichnet, dass**
vor Schritt b) ein Fenster (5) im Träger (4,400) ausgebildet wird, wobei der Träger für das Fenster abgedünnt oder ausgespart wird, wobei durch das Abdünnen oder Aussparen eine mechanisch stabilisierende Wirkung des Trägers für den Halbleiterkörper im Bereich des Fensters verringert wird, so dass eine Krümmung des Halbleiterkörpers vereinfacht erfolgen kann.

18. Verfahren nach Anspruch 17,
**dadurch gekennzeichnet, dass**
der Träger (4,400) das Aufwachssubstrat, auf dem der Halbleiterkörper (1,100) epitaktisch gewachsen wurde, umfasst.

19. Verfahren nach Anspruch 17 oder 18,
**dadurch gekennzeichnet, dass**
das Fenster von der dem Halbleiterkörper (1,100) abgewandten Seite des Trägers (4,400) bis zum Halbleiterkörper reicht.

20. Verfahren nach einem der Ansprüche 17 bis 19,
**dadurch gekennzeichnet, dass**
eine Verspannungsschicht (8,800) als Krümmungselement auf den Halbleiterkörper (1,100) aufgebracht wird, die den Halbleiterkörper, insbesondere in einem dem Fenster in vertikaler Richtung nachgeordneten Bereich, über mittels der Verspannungsschicht induzierte Druckverspannung oder Zugverspannung krümmt.

21. Verfahren nach Anspruch 20,
**dadurch gekennzeichnet, dass**
die Verspannungsschicht (8,800) ein Metall oder eine Legierung enthält.

22. Verfahren nach Anspruch 20 oder 21,
**dadurch gekennzeichnet, dass**
die Verspannungsschicht (8,800) auf den Halbleiterkörper (1,100) gesputtert oder gedampft wird.

23. Verfahren nach einem der Ansprüche 20 bis 22,
**dadurch gekennzeichnet, dass**
die Verspannungsschicht (8,800) auf die dem Träger (4,400) gegenüberliegende Seite des Halbleiterkörpers (1,100) aufgebracht wird.

24. Verfahren nach einem der Ansprüche 20 bis 23,
**dadurch gekennzeichnet, dass**
die durch die Verspannungsschicht (8,800) induzierte Krümmung mittels einer auf die Verspannungsschicht aufgebrachten Stabilisationsschicht (9,900) mechanisch stabilisiert wird.

25. Verfahren nach Anspruch 24,
**dadurch gekennzeichnet, dass**
die Stabilisationsschicht (9,900) galvanisch aufgebracht wird.

26. Verfahren nach einem der Ansprüche 17 bis 25,
**dadurch gekennzeichnet, dass**
dem Halbleiterkörper (1,100) ein Formelement (600) als Krümmungselement nachgeordnet wird, das einen gemäß der gewünschten Krümmung des Halbleiterkörpers geformten Bereich aufweist, an den sich der Halbleiterkörper, insbesondere in einem mit dem Fenster (5) überlappenden Bereich, andrückt oder angedrückt wird.

27. Verfahren nach einem der Ansprüche 17 bis 26,
**dadurch gekennzeichnet, dass**
gleichzeitig eine Mehrzahl von Halbleiterbauelementen im Waferverbund (100,400) herstellbar ist.

28. Verfahren nach einem der Ansprüche 17 bis 27,
**dadurch gekennzeichnet, dass**
das Verfahren zur Herstellung eines Halbleiterbauelements gemäß einem der Ansprüche 1 bis 16 vorgesehen ist.

29. Verwendung eines epitaktisch auf einem Aufwachssubstrat gewachsenen ebenen Halbleiterkörpers (1), der einen monolithisch integrierten Spiegel (3) aufweist, zur Herstellung eines Halbleiterbauelements mit einem gekrümmten Spiegel durch Krümmung des Halbleiterkörpers, wobei ein die Krümmung induzierendes oder formendes Krümmungselement (600,800,8) auf der dem Träger (4,400) abgewandten Seite des Halbleiterkörpers (1) angeordnet wird, und wobei das Krümmungselement auf den Halbleiterkörper auf der dem Träger abgewandten Seite aufgebracht oder dem Halbleiterkörper auf der dem Träger abgewandten Seite nachgeordnet wird.

30. Verwendung nach Anspruch 29,
**dadurch gekennzeichnet, dass**
der Halbleiterkörper (1) eine zur Strahlungserzeugung vorgesehene aktive Zone (2) aufweist.

31. Verwendung nach Anspruch 29 oder 30,
**dadurch gekennzeichnet, dass**
der Halbleiterkörper (1) in einem Halbleiterbauelement nach einem der Ansprüche 1 bis 16 verwendet wird.

## Claims

1. Semiconductor component having a semiconductor body (1), the semiconductor body comprising a curved mirror (3), which is monolithically integrated in the semiconductor body, and the semiconductor body (1) being arranged on a carrier (4, 400),
**characterized in that**
a curvature element (600, 800, 8) that induces or shapes the curvature is arranged on that side of the semiconductor body (1) which faces away from the carrier (4, 400), the curvature element being applied to the semiconductor body on the side facing away from the carrier or being disposed downstream of the semiconductor body on the side facing away from the carrier.

2. Semiconductor component according to Claim 1,
**characterized in that**
the semiconductor body (1) and the curved mirror (3) have a curvature of identical type.

3. Semiconductor component according to Claim 1 or 2,
**characterized in that**
the curved mirror (3) is a Bragg mirror.

4. Semiconductor component according to one of the preceding claims,
**characterized in that**
the carrier (4, 400) is planar.

5. Semiconductor component according to one of the preceding claims,
**characterized in that**
the semiconductor body (1) has at least one partial region that is curved for the curved mirror (3) and at least one planar partial region.

6. Semiconductor component according to Claim 5,
**characterized in that**
a window (5) is arranged downstream of the curved partial region in the vertical direction, the carrier (4, 400) being thinned or cut out in said window.

7. Semiconductor component according to Claim 6,
**characterized in that**
the curved partial region overlaps, preferably completely overlaps, the window (5) in the vertical direction.

8. Semiconductor component according to one of the preceding claims,
**characterized in that**
the curvature element (600, 800, 8) is a metal-containing stress layer (800, 8) applied to the semiconductor body (1).

9. Semiconductor component according to one of the preceding claims,
**characterized in that**
the semiconductor body (1) has an active zone (2) provided for the generation of radiation.

10. Semiconductor component according to Claim 9,
**characterized in that**
the semiconductor component is a surface emitting semiconductor component.

11. Semiconductor component according to Claim 9 or 10,
**characterized in that**
the semiconductor component is provided for the generation of laser radiation (13) by means of an external resonator and, for the external resonator, provision is made for arranging an external mirror (1) downstream of the active zone (2).

12. Semiconductor component according to Claim 11,
**characterized in that**
the external mirror (11) is embodied in planar fashion.

13. Semiconductor component according to one of Claims 9 to 12,
**characterized in that**
the active zone (2) for the generation of radiation is optically pumped by means of at least one pump radiation source (120), in particular a pump laser.

14. Semiconductor component according to Claim 13,
**characterized in that**
the pump radiation source (120) and the semiconductor body (1) are monolithically integrated on a common growth substrate.

15. Semiconductor component according to one of Claims 9 to 14,
**characterized in that**
there is arranged in the external resonator a nonlinear optical element (16) for frequency conversion, in particular for frequency multiplication, of the radiation (13) generated in the active zone.

16. Semiconductor component according to one of the preceding claims,
**characterized in that**
the carrier (4, 400) comprises the growth substrate on which the semiconductor body (1, 100) is grown epitaxially.

17. Method for producing a semiconductor component having a curved semiconductor body,
comprising the steps of
a) providing a semiconductor body (1, 100) which is arranged on a carrier (4, 400),
b) curving the semiconductor body, a curvature element (600, 800, 8) that induces or shapes the curvature being arranged on that side of the semiconductor body (1) which faces away from the carrier (4, 400) and the curvature element being applied to the semiconductor body on the side facing away from the carrier or being disposed downstream of the semiconductor body on the side facing away from the carrier,
c) completing the semiconductor component **characterized in that**
a window (5) is formed in the carrier (4, 400) prior to step b), the carrier being thinned or cut out for the window, wherein the thinning or cutting out reduces a mechanically stabilizing effect of the carrier for the semiconductor body in the region of the window, such that a curvature of the semiconductor body can be effected in a simplified manner.

18. Method according to Claim 17,
**characterized in that**
the carrier (4, 400) comprises the growth substrate on which the semiconductor body (1, 100) was grown epitaxially.

19. Method according to Claim 17 or 18,
**characterized in that**
the window reaches from that side of the carrier (4, 400) which is remote from the semiconductor body (1, 100) as far as the semiconductor body.

20. Method according to one of Claims 17 to 19,
**characterized in that**
a stress layer (8, 800) is applied to the semiconductor body (1, 100) as a curvature element, which stress layer curves the semiconductor body, in particular in a region arranged downstream of the window in the vertical direction, by way of compressive stress or tensile stress induced by means of the stress layer.

21. Method according to Claim 20,
**characterized in that**
the stress layer (8, 800) contains a metal or an alloy.

22. Method according to Claim 20 or 21,
**characterized in that**
the stress layer (8, 800) is sputtered or vapor-deposited onto the semiconductor body (1, 100).

23. Method according to one of Claims 20 to 22,
**characterized in that**
the stress layer (8, 800) is applied to the opposite side of the semiconductor body (1, 100) from the carrier (4, 400).

24. Method according to one of Claims 20 to 23,
**characterized in that**
the curvature induced by the stress layer (8, 800) is mechanically stabilized by means of a stabilization layer (9, 900) applied to the stress layer.

25. Method according to Claim 24,
**characterized in that**
the stabilization layer (9, 900) is applied galvanically.

26. Method according to one of Claims 17 to 25,
**characterized in that**
a shaped element (600) is arranged downstream of the semiconductor body (1, 100) as a curvature element, which has a region which is shaped in accordance with the desired curvature of the semiconductor body and onto which the semiconductor body presses or is pressed in particular in a region that overlaps the window (5).

27. Method according to one of Claims 17 to 26,
**characterized in that**
a plurality of semiconductor components can be produced simultaneously in the wafer assembly (100, 400).

28. Method according to one of Claims 17 to 27,
**characterized in that**
the method is provided for producing a semiconductor component according to one of Claims 1 to 16.

29. Use of a planar semiconductor body (1) grown epitaxially on a growth substrate, said semiconductor body having a monolithically integrated mirror (3), for producing a semiconductor component having a curved mirror as a result of the curvature of the semiconductor body, a curvature element (600, 800, 8) that induces or shapes the curvature being arranged on that side of the semiconductor body (1) which faces away from the carrier (4, 400), and the curvature element being applied to the semiconductor body on the side facing away from the carrier or being disposed downstream of the semiconductor body on the side facing away from the carrier.

30. Use according to Claim 29,
**characterized in that**
the semiconductor body (1) has an active zone (2) provided for generating radiation.

31. Use according to Claim 29 or 30,
**characterized in that**
the semiconductor body (1) is used in a semiconductor component according to one of Claims 1 to 16.

## Revendications

1. Composant semiconducteur comprenant un corps en semiconducteur (1),
le corps en semiconducteur comprenant un miroir courbe (3) qui est intégré de manière monolithique dans le corps en semiconducteur, et le corps en semiconducteur (1) étant disposé sur un support (4, 400),
**caractérisé en ce que**
un élément de courbure (600, 800, 8) induisant ou formant la courbure est disposé sur le côté du corps en semiconducteur (1) à l'opposé du support (4, 400), l'élément de courbure étant appliqué sur le corps en semiconducteur sur le côté à l'opposé du support ou étant disposé à la suite du corps en semiconducteur sur le côté à l'opposé du support.

2. Composant semiconducteur selon la revendication 1, **caractérisé en ce que** le corps en semiconducteur (1) et le miroir courbe (3) présentent une courbure identique.

3. Composant semiconducteur selon la revendication 1 ou 2, **caractérisé en ce que** le miroir courbe (3) est un miroir de Bragg.

4. Composant semiconducteur selon l'une des revendications précédentes, **caractérisé en ce que** le support (4, 400) est plan.

5. Composant semiconducteur selon l'une des revendications précédentes, **caractérisé en ce que** le corps en semiconducteur (1) possède au moins une zone partielle courbe pour le miroir courbe (3) et au moins une zone partielle plane.

6. Composant semiconducteur selon la revendication 5, **caractérisé en ce que** la zone partielle courbe est disposée, dans le sens vertical, à la suite d'une fenêtre (5) dans laquelle le support (4, 400) est aminci ou évidé.

7. Composant semiconducteur selon la revendication 6, **caractérisé en ce que** la zone partielle courbe, dans le sens vertical, chevauche la fenêtre (5), de préférence entièrement.

8. Composant semiconducteur selon l'une des revendications précédentes, **caractérisé en ce que** l'élément de courbure (600, 800, 8) est une couche de déformation (800, 8) contenant du métal appliquée sur le corps en semiconducteur (1).

9. Composant semiconducteur selon l'une des revendications précédentes, **caractérisé en ce que** le corps en semiconducteur (1) possède une zone active (2) conçue pour générer un rayonnement.

10. Composant semiconducteur selon la revendication 9, **caractérisé en ce que** le composant semiconducteur est un composant semiconducteur à émission par la surface.

11. Composant semiconducteur selon la revendication 9 ou 10, **caractérisé en ce que** le composant semiconducteur est conçu pour générer un rayonnement laser (13) au moyen d'un résonateur externe et, pour le résonateur externe, il est prévu de disposer un miroir externe (11) à la suite de la zone active (2).

12. Composant semiconducteur selon la revendication 11, **caractérisé en ce que** le miroir externe (11) est réalisé plan.

13. Composant semiconducteur selon l'une des revendications 9 à 12, **caractérisé en ce que** la zone active (2), en vue de la génération d'un rayonnement, est pompée optiquement au moyen d'au moins une source de rayonnement de pompage (120), notamment un laser de pompage.

14. Composant semiconducteur selon la revendication 13, **caractérisé en ce que** la source de rayonnement de pompage (120) et le corps en semiconducteur (1) sont intégrés de manière monolithique sur un substrat de croissance commun.

15. Composant semiconducteur selon l'une des revendications 9 à 14, **caractérisé en ce qu'**un élément optique non linéaire (16) servant à la conversion de fréquence, notamment à la multiplication de la fréquence du rayonnement (13) généré dans la zone active, est disposé dans le résonateur externe.

16. Composant semiconducteur selon l'une des revendications précédentes, **caractérisé en ce que** le support (4, 400) comprend le substrat de croissance sur lequel le corps en semiconducteur (1, 100) est mis en croissance épitaxiale.

17. Procédé de fabrication d'un composant semiconducteur ayant un corps en semiconducteur courbe,
comprenant les étapes suivantes
a) mise à disposition d'un corps en semiconducteur (1, 100) qui est disposé sur un support (4, 400),
b) courbure du corps en semiconducteur, un élément de courbure (600, 800, 8) induisant ou formant la courbure étant disposé sur le côté du corps en semiconducteur (1) à l'opposé du support (4, 400), l'élément de courbure étant appliqué sur le corps en semiconducteur sur le côté à l'opposé du support ou étant disposé à la suite du corps en semiconducteur sur le côté à l'opposé du support,
c) achèvement du composant semiconducteur, **caractérisé en ce que**
avant l'étape b), une fenêtre (5) est formée dans le support (4, 400), le support étant aminci ou évidé pour la fenêtre, un effet mécaniquement stabilisant du support pour le corps en semiconducteur dans la zone de la fenêtre étant réduit du fait de l'amincissement ou de l'évidement, ce qui permet de réaliser plus facilement une courbure du corps en semiconducteur.

18. Procédé selon la revendication 17, **caractérisé en ce que** le support (4, 400) comprend le substrat de croissance sur lequel le corps en semiconducteur (1, 100) est mis en croissance épitaxiale.

19. Procédé selon la revendication 17 ou 18, **caractérisé en ce que** la fenêtre s'étend du côté du support (4, 400) à l'opposé du corps en semiconducteur (1, 100) jusqu'au corps en semiconducteur.

20. Procédé selon l'une des revendications 17 à 19, **caractérisé en ce qu'**une couche de déformation (8, 800) faisant office d'élément de courbure est appliquée sur le corps en semiconducteur (1, 100), laquelle courbe le corps en semiconducteur, notamment dans une zone disposée à la suite de la fenêtre dans le sens vertical, par le biais d'une contrainte de pression ou d'une contrainte de traction induite au moyen de la couche de déformation.

21. Procédé selon la revendication 20, **caractérisé en ce que** la couche de déformation (8, 800) contient un métal ou un alliage.

22. Procédé selon la revendication 20 ou 21, **caractérisé en ce que** la couche de déformation (8, 800) est appliquée par pulvérisation cathodique ou par vaporisation sur le corps en semiconducteur (1, 100).

23. Procédé selon l'une des revendications 20 à 22, **caractérisé en ce que** la couche de déformation (8, 800) est appliquée sur le côté du corps en semiconducteur (1, 100) à l'opposé du support (4, 400).

24. Procédé selon l'une des revendications 20 à 23, **caractérisé en ce que** la courbure induite par la couche de déformation (8, 800) est stabilisée mécaniquement au moyen d'une couche de stabilisation (9, 900) appliquée sur la couche de déformation.

25. Procédé selon la revendication 24, **caractérisé en ce que** la couche de stabilisation (9, 900) est appliquée par procédé galvanique.

26. Procédé selon l'une des revendications 17 à 25, **caractérisé en ce qu'**un élément de formage (600) est disposé à la suite du corps en semiconducteur (1, 100) en tant qu'élément de courbure, lequel possède une zone façonnée conformément à la courbure souhaitée du corps en semiconducteur et contre lequel le corps en semiconducteur s'appuie ou est poussé, notamment dans une zone qui chevauche la fenêtre (5).

27. Procédé selon l'une des revendications 17 à 26, **caractérisé en ce qu'**une pluralité de composants semiconducteurs peuvent être fabriqués simultanément dans un composé en galette (100, 400).

28. Procédé selon l'une des revendications 17 à 27, **caractérisé en ce que** le procédé est conçu pour la fabrication d'un composant semiconducteur selon l'une des revendications 1 à 16.

29. Utilisation d'un corps en semiconducteur (1) plan ayant cru sur un substrat de croissance, lequel possède un miroir (3) intégré de manière monolithique, pour la fabrication d'un composant semiconducteur comprenant un miroir courbe par courbure du corps en semiconducteur, un élément de courbure (600, 800, 8) induisant ou formant la courbure étant disposé sur le côté du corps en semiconducteur (1) à l'opposé du support (4, 400), l'élément de courbure étant appliqué sur le corps en semiconducteur sur le côté à l'opposé du support ou étant disposé à la suite du corps en semiconducteur sur le côté à l'opposé du support.

30. Utilisation selon la revendication 29, **caractérisée en ce que** le corps en semiconducteur (1) possède une zone active (2) conçue pour générer un rayonnement.

31. Utilisation selon la revendication 29 ou 30, **caractérisée en ce que** le corps en semiconducteur (1) est utilisé dans un composant semiconducteur selon l'une des revendications 1 à 16.
